# EUROPEAN PATENT APPLICATION

(11) **EP 4 704 087 A2**
(43) Date of publication of application: **04.03.2026**
(21) Application number: 25197938.1
(22) Date of filing: 25.08.2025
(51) Int. Cl.: G11C 29/12, G11C 29/00, G11C 29/02, G11C 29/44, G11C 29/36

(54) **INTERCONNECT REPAIR SYSTEMS AND METHODS FOR INTEGRATED CIRCUITS**

(30) Priority: 29.08.2024 US 202463688324 P; 25.04.2025 US 202519189597
(71) Applicant: Avago Technologies International Sales Pte. Limited, Singapore 768923 (SG)
(72) Inventor: Zhou, Ting, Orinda 94563 (US)
(74) Representative: Dilg, Haeusler, Schindelmann Patentanwaltsgesellschaft mbH

(57) **Abstract**

Interconnect repair systems and methods for integrated circuits (e.g., 3D integrated circuits, 2.5D integrated circuits, etc.). An example integrated circuit (100) includes a first circuit die (200), a second circuit die (300), and an interconnect layer (400). The first circuit die (200) transmits a test pattern to the second circuit die (300) via the interconnect layer (400). Then, the second circuit die (300) determines that a first interconnect has failed based on the test pattern and generates a signature. Finally, the second circuit die (300) uses signatures to cause deactivation of the first interconnect and activation of a second interconnect on both the first circuit die (200) and the second circuit die (300). The disclosed interconnect repair systems and methods can be used to provide various advantages.

## Description

### CROSS-REFERENCE TO RELATED APPLICATION

This application claims the benefit of and priority to U.S. Provisional Patent Application No. 63/688,324, filed August 29, 2024, the entirety of which is incorporated by reference herein.

### BACKGROUND

The present disclosure relates, in general, to packaging and interconnection of various types of electronic circuits and associated technologies. As packing technologies for various types of integrated circuits continue to become more advanced, the ability to detect and repair connection failures becomes more difficult and more critical. Accordingly, new technologies that can help detect and repair connection failures in various types of electronic circuits are generally desired.

### BRIEF DESCRIPTION OF THE DRAWINGS

FIG. 1 is a block diagram showing components of an example integrated circuit including an interconnect repair system, in accordance with some aspects of the disclosure.
FIG. 2 is a block diagram showing components associated with an example transmitting (TX) repair control circuit that can be used in the interconnect repair system of FIG. 1, in accordance with some aspects of the disclosure.
FIG. 3 is a block diagram showing components associated with an example receiving (RX) repair control circuit that can be used in the interconnect repair system of FIG. 1, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

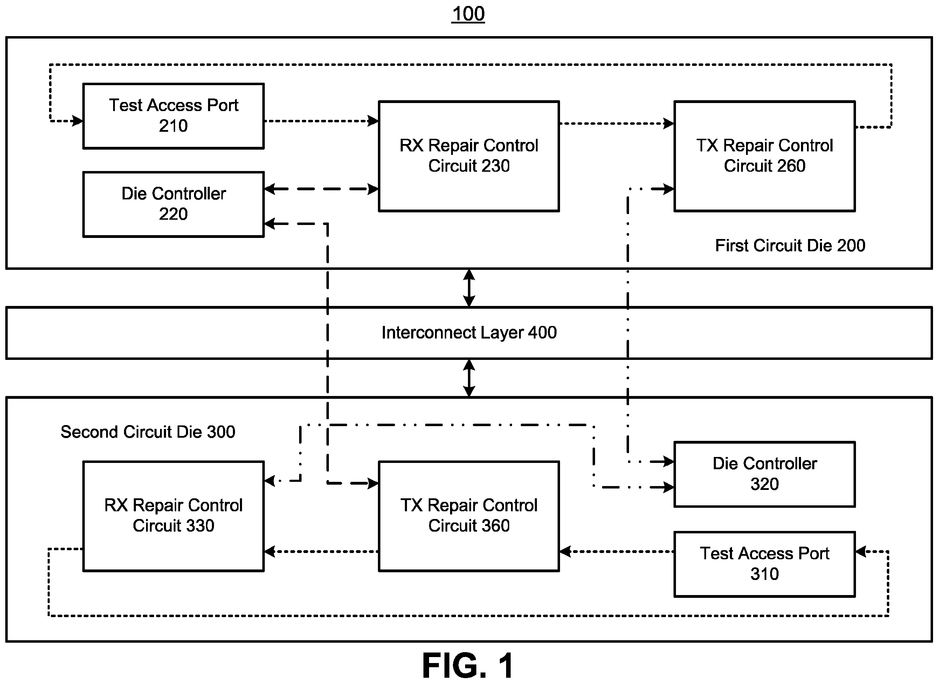

Referring to FIG. 1, a block diagram illustrating components of an integrated circuit 100 that includes an interconnect repair system is shown, in accordance with some aspects of the disclosure. The integrated circuit 100 can be implemented using various types of integrated circuits (ICs). For example, the integrated circuit 100 can be implemented as a three-dimensional (3D) integrated circuit that includes any suitable number of circuit dies stacked and interconnected within a single package. The integrated circuit 100 can also be implemented as a "2.5D" integrated circuit that includes any suitable number of circuit dies disposed side-by-side (e.g., on an interposer), for example, among various other suitable types of integrated circuits. In these types of integrated circuits, fine pitch interconnects (e.g., copper-to-copper interconnects) can be used to electrically connect the various circuit dies together. However, the manufacturing processes used to make these types of integrated circuits and associated packages may not be perfect, thereby resulting in some of the interconnects not being connected properly after the manufacturing process is completed. The interconnect repair system as implemented in the integrated circuit 100 can be used to fix at least some of the failed interconnects after the manufacturing process is completed. The failed interconnects fixed by the interconnect repair system as implemented in the integrated circuit 100 can be completely failed interconnects (e.g., no signal communication can occur at all on the interconnect) or partially failed interconnects (e.g., some amount of signal disruption occurs on the interconnect, but intermittent communication may be possible).

In general, the interconnect repair system as implemented in the integrated circuit 100 can use a built-in self-test (BIST) approach to identify and then fix failed interconnects. The BIST-based approach used in the interconnect repair system as implemented in the integrated circuit 100 can provide a more desirable alternative to some previous, more scan-based solutions that may be associated with a variety of drawbacks. For example, some scan-based solutions may require long testing time periods, may require repair decisions to be made off-chip, may require updated test software with design-specific configurations for each and every new design, and/or may struggle in generating a single set of test patterns to cover both pre-repair and post-repair scenarios.

As shown in FIG. 1, the integrated circuit 100 can include a first circuit die 200, a second circuit die 300, and an interconnect layer 400. The first circuit die 200 and the second circuit die 300 can be any of a variety of suitable types of circuit dies. For example, the first circuit die 200 can be a central processing unit (CPU) die 200, and the second circuit die 300 can be a "base" die. In such an example, the first circuit die 200, the second circuit die 300, and the die interface 400 can be provided within a single 3D integrated circuit package that is suitable for use in a variety of artificial intelligence (AI) applications (e.g., for use in a data center, etc.). The interconnect layer 400 can include various suitable types of interconnects that electrically connect the first circuit die 200 and the second circuit die 300. For example, the interconnect layer 400 can be implemented at least in part as a hybrid copper bonding (HCB) interconnect layer that includes a plurality a fine pitch, high density interconnects. The interconnect layer 400 can additionally or alternatively be implemented using through-silicon vias (TSVs) and/or various suitable types of microbumps (e.g., in a ball grid array (BGA), etc.), for example. The interconnect layer 400 can include redundant interconnects that electrically connect the first circuit die 200 and the second circuit die 300 (e.g., a first interconnect and a redundant second interconnect, a third interconnect and a redundant fourth interconnect, etc.).

As shown in FIG. 1, the first circuit die 200 can include a test access port (TAP) 210, a die (chip) controller 220, an RX repair control circuit 230, and a TX repair control circuit 260. The TAP 210, the die controller 220, the RX repair control circuit 230, and the TX repair control circuit 260 can each be implemented using various suitable types of electronic components and circuits. Also, while FIG. 1 illustrates the first circuit die 200 as including one RX repair control circuit and one TX repair control circuit, it should be noted that the first circuit die 200 can include any suitable number of TX and RX repair control circuits similar to the RX repair control circuit 230 and the TX repair control circuit 260, depending on the application. In such implementations, the additional TX and RX repair control circuits can be chained together along the various communication paths illustrated in FIG. 1 (e.g., in a daisy-chain configuration, etc.).

As shown in FIG. 1, the second circuit die 300 can similarly include a TAP 310, a die (chip) controller 320, an RX repair control circuit 330, and a TX repair control circuit 360. The TAP 310, the die controller 320, the RX repair control circuit 330, and the TX repair control circuit 360 can each be implemented using various suitable types of electronic circuits and electronic components. Again, while FIG. 1 illustrates the second circuit die 300 as including one RX repair control circuit and one TX repair control circuit, it should be noted that the second circuit die 300 can include any suitable number of TX and RX repair control circuits similar to the RX repair control circuit 330 and the TX repair control circuit 360, depending on the application. In such implementations, the additional TX and RX repair control circuits can be chained together along the various communication paths illustrated in FIG. 1 (e.g., in a daisy-chain configuration, etc.).

The TAP 210 can generally be used to provide an interface to manage access to embedded instruments on the first circuit die 200. For example, the TAP 210 can provide access to BIST circuits (e.g., the RX BIST circuit 240, the TX BIST circuit 270 as detailed further below), sensors (e.g., voltage, temperature, etc.), calibration circuits, performance monitors, and/or other suitable instruments on the first circuit die 200. The TAP 210 can generally configure and use a Segmented Instrument Access Network (SIAN) on the first circuit die 200 to manage access to instruments on the first circuit die 200 in accordance with Internal Joint Test Action Group (iJTAG) standards and/or Joint Test Action Group (JTAG) standards, among other possible standards. For example, as shown in FIG. 1, the TAP 210 can communicate with both the RX repair control circuit 230 and the TX repair control circuit 260 via the SIAN in accordance with iJTAG standards. The TAP 210 can send an instruction to the TX repair control circuit 260 that causes the TX repair control circuit 260 to transmit a test pattern to the RX repair control circuit 330 on the second circuit die 300 via the interconnect layer 400 to begin a BIST process.

The die controller 220 can be responsible for various actions as part of the interconnect repair system as implemented in the integrated circuit 100. As shown in FIG. 1, the RX repair control circuit 230 and the TX repair control circuit 360 are both in communication with the die controller 220. However, the TX repair control circuit 260 is skipped and is not included in the communication path connecting the RX repair control circuit 230, the TX repair control circuit 360, and the die controller 220. With this design, side band (or side channel) communications in the integrated circuit 100 can be reduced when compared to some previous approaches because the communication between the RX repair control circuit 230 and the TX repair control circuit 360 can be limited to just the sending of the test pattern from the TX repair control circuit 360 to the RX repair control circuit 230. The die controller 220 can efficiently gather information regarding specific interconnects within the interconnect layer 400 that have failed from the RX repair control circuit 230 after a BIST process is performed. While not explicitly shown in FIG. 1, the TX repair control circuit 260 can transmit data from the first circuit die 200 via the interconnect layer 400, and the RX repair control circuit 330 can receive the data transmitted by the TX repair control circuit 260 on the second circuit die 300. Similarly, the TX repair control circuit 360 can transmit data from the second circuit die 300 via the interconnect layer 400, and the RX repair control circuit 230 can receive the data transmitted by the TX repair control circuit 360 on the first circuit die 200.

The TAP 310 can, similar to the TAP 210, generally be used to provide an interface to manage access to embedded instruments on the second circuit die 300. For example, the TAP 310 can provide access to BIST circuits, sensors (e.g., voltage, temperature, etc.), calibration circuits, performance monitors, and/or other suitable instruments on the second circuit die 300. The TAP 310 can generally configure and use a SIAN on the second circuit die 300 to manage access to instruments on the second circuit die 300 in accordance with iJTAG standards and/or JTAG standards, among other possible standards. For example, as shown in FIG. 1, the TAP 310 can communicate with both the TX repair control circuit 360 and the RX repair control circuit 330 via the SIAN in accordance with iJTAG standards. The TAP 310 can send an instruction to the TX repair control circuit 360 that causes the TX repair control circuit 360 to transmit a test pattern to the RX repair control circuit 230 on the first circuit die 200 via the interconnect layer 400 to begin a BIST process.

The die controller 320, similar to the die controller 220, can be responsible for various actions as part of the interconnect repair system as implemented in the integrated circuit 100. As shown in FIG. 1, the RX repair control circuit 330 and the TX repair control circuit 260 are both in communication with the die controller 320. However, the TX repair control circuit 360 is skipped and is not included in the communication path connecting the RX repair control circuit 330, the TX repair control circuit 260, and the die controller 320. With this design, side band (or side channel) communications in the integrated circuit 100 can again be reduced when compared to some previous approaches because the communication between the RX repair control circuit 330 and the TX repair control circuit 260 can be limited to just the sending of the test pattern from the TX repair control circuit 260 to the RX repair control circuit 330. The die controller 320 can efficiently gather information regarding specific interconnects within the interconnect layer 400 that have failed from the RX repair control circuit 330 after a BIST process is performed.

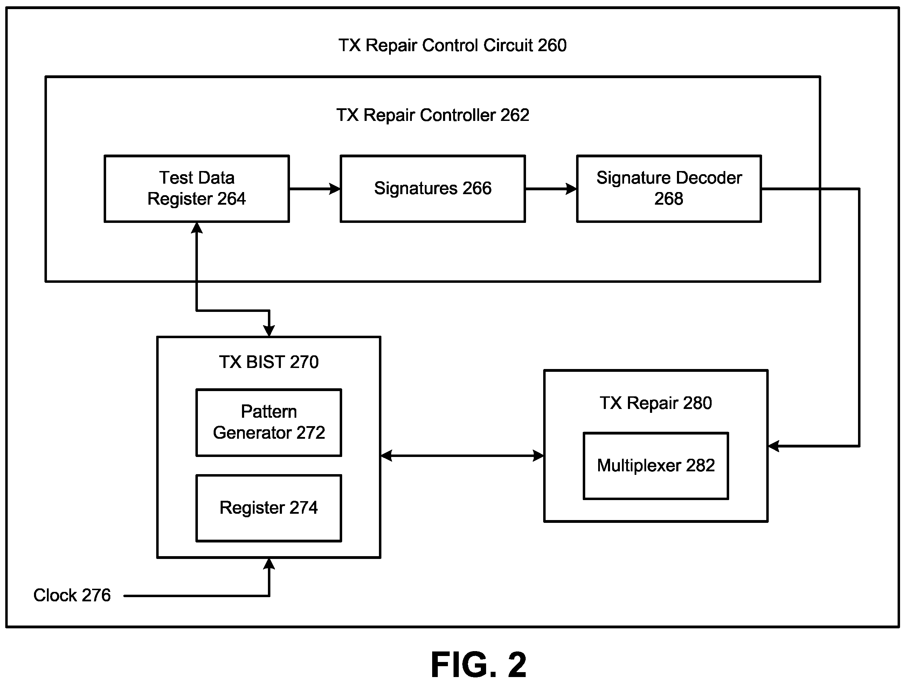

Referring to FIG. 2, a block diagram illustrating example components of the TX repair control circuit 260 is shown, in accordance with some aspects of the disclosure. The TX repair control circuit 360 can be implemented using similar components and functionality as the TX repair control circuit 260. As shown, the TX repair control circuit 260 can include a TX repair controller 262, a TX BIST circuit 270, and a TX repair circuit 280. The TX repair controller 262 can include a test data register (TDR) 264, signatures 266, and a signature decoder 268. The test data register 264 can be used to hold and transfer BIST-related data between the TX repair control circuit 260 and other components of the integrated circuit 100. For example, the test data register 264 can be used to store instructions received from the TAP 210. The signatures 266 can include data indicative of failed interconnects included in the interconnect layer 400. The signatures 266 can be stored in a shift register of the TX repair controller 262, and can be sent to and from the die controller 320. The signatures 266 can also be stored in other suitable types of registers of the TX repair controller 262 (e.g., a shadow register). The signature decoder 268 can include any suitable circuitry to decode the signatures 266 and determine appropriate control actions based on the signatures 266. For example, the signatures 266 can indicate that a first interconnect included in the interconnect layer 400 has failed. In such an example, the signature decoder 268 can decode the signatures 266 to identify the first interconnect and a second interconnect that is a redundant interconnect associated with the first interconnect. Then, the signature decoder 268 can second a control signal to the TX repair circuit 280 such that the TX repair circuit 280 can use the control signal to deactivate the first interconnect and activate the second interconnect.

The TX repair circuit 280, as shown in FIG. 2, can include a multiplexer 282 among other possible components. The multiplexer 282 can be implemented using various suitable components and multiplexer configurations, including using multiple separate multiplexers. In some examples, the TX repair circuit 280 may not necessarily include the multiplexer 282. Instead, the TX repair circuit 280 can be implemented using alternative components such as fuses (e.g., electronic fuses ("e-fuses"), metal fuses, etc.), heating components, and/or other suitable components. In general, the TX repair circuit 280 be configured to repair failed interconnects included in the interconnect layer 400 and/or otherwise mitigate the effects of failed interconnects included in the interconnect layer 400. For example, the TX repair circuit 280 can receive a control signal from the TX repair controller 262 and use the control signal to control the multiplexer 282. The TX repair circuit 280 can also blow one or more fuses or use self-heating to repair failed interconnects included in the interconnect layer 400. Accordingly, the TX repair circuit 280 can activate and deactivate various interconnects included in the interconnect layer 400 based on the results of a BIST (e.g., as reflected in the signatures 266). Also, it should be noted that the TX repair control circuit 260 can include any suitable number of TX repair circuits similar to the TX repair circuit 280.

The TX BIST circuit 270, as shown in FIG. 2, can include both a pattern generator circuit 272 as well as a register 274. The pattern generator circuit 272 can be implemented using various suitable components and electronic circuit configurations. In general, the pattern generator circuit 272 can be configured to generate and transmit a test pattern to the RX repair control circuit 330 on the second circuit die 300 via the interconnect layer 400. The test pattern can include any suitable data that can be sent from the TX BIST circuit 270 to the RX repair control circuit 330 on the second circuit die 300 to test one or more interconnects included in the interconnect layer 400. For example, the test pattern can be a sequence of bits (e.g., represented in decimal, hexadecimal, etc.), among other possible test patterns. In some examples, the pattern generator circuit 272 can be configured to generate two different test patterns that are the inverse of each other (e.g., 1011 and 0100, etc.) and that invert upon a new clock cycle. The number of bits in the test pattern can correspond to the number of interconnects in the interconnect layer 400 being tested (e.g., 256 bits for 256 interconnects). The register 274 can likewise be implemented using various suitable components, including using various quantities and configurations of flip-flops, latches, and/or other suitable components. The register 274 can be optionally included as part of the TX BIST circuit 270 and can be used to store any suitable data associated with the TX BIST circuit 270 (e.g., test patterns generated by the pattern generator circuit 272, etc.).

Also, as shown in FIG. 2, the TX BIST circuit 270 can be configured to receive and operate in accordance with a clock signal 276 during the process of completing a BIST. The clock signal 276 can generally be a faster clock signal than the clock signal used to operate components such as the die controller 220. For example, the die controller 220 and the TAP 210 can operate using a clock signal with a frequency in the range of tens of megahertz, whereas the clock signal 276 can have a frequency in the gigahertz range. The use of the clock signal 276 can generally improve the timing coordination of the BIST process performed by the integrated circuit 100 due to differences in communication frequencies that may exist between the TAP 210, the TAP 310, the die controller 220, and/or the die controller 320, for example. Accordingly, the use of the clock signal 276 can help with detection of intermittent (e.g., partially failed) interconnects included in the interconnect layer 400 as well as completely failed interconnects included in the interconnect layer 400. Upon completion of the BIST process, the TX BIST circuit 270 can be configured to disconnect the clock signal 276.

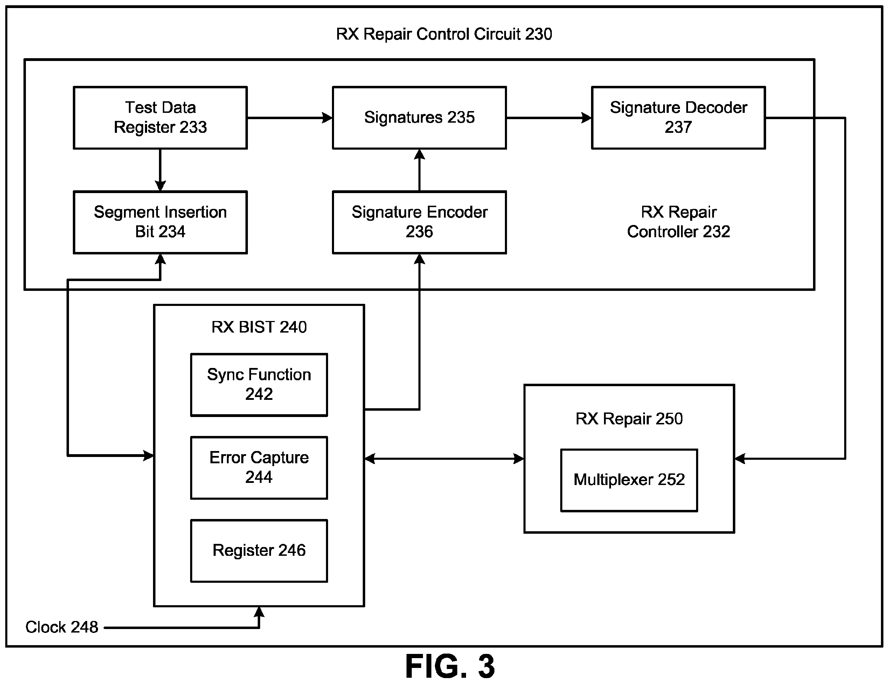

Referring to FIG. 3, a block diagram illustrating example components of the RX repair control circuit 230 is shown, in accordance with some aspects of the disclosure. The RX repair control circuit 330 can be implemented using similar components and functionality as the RX repair control circuit 230. As shown, the RX repair control circuit 230 can include a RX repair controller 232, an RX BIST circuit 240, and a RX repair circuit 250. The RX repair controller 232 can include a test data register (TDR) 233, a segment insertion bit (SIB) 234, signatures 235, a signature encoder 236, and a signature decoder 237. The test data register 233 can be used to hold and transfer BIST-related data between the RX repair control circuit 230 and other components of the integrated circuit 100. For example, the test data register 233 can be used to store instructions received from the TAP 210 and the die controller 220. The segment insertion bit 234 can be optionally included in the RX repair control circuit 230, and can be used to control the RX repair control circuit 230 by enabling or disabling the RX repair control circuit 230 for a given BIST process (e.g., to enable or disable certain debugging functionality within the integrated circuit 100). For example, in implementation where the first circuit die 200 includes multiple RX repair control circuits, the TAP 210 and/or the die controller 220 can use segment insertion bit 234 to enable testing of only certain parts of the interconnect layer 400 instead of testing the entire interconnect layer 400.

The signatures 235 can include any data (e.g., any suitable binary representations, etc.) that is indicative of failed interconnects included in the interconnect layer 400. The signatures 235 can be the same as the signatures 266 and can be stored in a shift register of the RX repair controller 232. The signatures 235 can also be stored in other suitable types of registers of the RX repair controller 232 (e.g., a shadow register). For example, the signature encoder 236 can communicate with the RX BIST circuit 240 to determine which of the interconnects included in the interconnect layer 400 failed a given BIST process. The signature encoder 236 can then compress that data into the signatures 235 such that the signatures 235 can be efficiently passed to other components of the integrated circuit 100. The signature encoder 236 can also perform overflow detection (determining whether there are more interconnect failures than repair capacity (e.g., number of available redundant interconnects, etc.)) for the any of the components of the RX repair control circuit 230 (e.g., the test data register 233, the shift register that stores the signatures 235, etc.). The RX repair control circuit 230 can transmit the signatures to die controller 220 to indicate failed interconnects to the die controller 220. Then, the die controller 220 can store the signatures 235 in a non-volatile memory of the die controller 220 such that, upon power up, the signatures 235 can be retrieved and used to repair any failed interconnects included in the interconnect layer 400 without receiving any instruction via the TAP 210 and without running another BIST process.

Then, the signature decoder 237 can decode the signatures 235 and determine appropriate control actions based on the signatures 235. For example, the signatures 235 can indicate that a first interconnect included in the interconnect layer 400 has at least partially failed. In such an example, the signature decoder 237 can decode the signatures 235 to identify the first interconnect and a second interconnect that is a redundant interconnect associated with the first interconnect. Then, the signature decoder 237 can second a control signal to the RX repair circuit 250 such that the RX repair circuit can use the control signal to deactivate the first interconnect and activate the second interconnect. The signature encoder 236 and the signature decoder 237 can include any suitable circuitry for performing the encoding and decoding of the signatures 235.

The RX repair circuit 250, as shown in FIG. 3, can include a multiplexer 252 among other possible components. The multiplexer 252 can again be implemented using any suitable components and multiplexer configurations, including using multiple separate multiplexers. In some examples, the RX repair circuit 250 may not necessarily include the multiplexer 252 and/or the register 246. Instead, in such examples, the RX repair circuit 250 can be implemented using alternative components such as fuses (e.g., electronic fuses, metal fuses, etc.), heating components, and/or other suitable types of components. In general, the RX repair circuit 250 can repair failed interconnects included in the interconnect layer 400 and/or otherwise mitigate the effects of failed interconnects included in the interconnect layer 400. For example, the RX repair circuit 250 can receive a control signal from the RX repair controller 232 and use the control signal to control the multiplexer 252. The RX repair circuit 250 can also blow one or more fuses or use self-heating to repair failed interconnects included in the interconnect layer 400. Accordingly, the RX repair circuit 250 can activate and deactivate various interconnects included in the interconnect layer 400 based on the results of a BIST (e.g., as reflected in the signatures 235). Also, it should be noted that the RX repair control circuit 230 can include any suitable number of RX repair circuits similar to the RX repair circuit 250.

The RX BIST circuit 240, as shown in FIG. 3, can include a synchronization ("auto-sync") circuit 242, an error capture circuit 244, and a register 246. The synchronization circuit 242 can be implemented using various suitable components and electronic circuit configurations. The synchronization circuit 242 can generally be configured to synchronize a test pattern (e.g., as received from the TX repair control circuit 360 on the second circuit die 300) with an expected pattern to ensure proper comparison between the test pattern and the expected pattern. For example, the synchronization circuit 242 can compare a portion of the test pattern received from the TX repair control circuit 360 as part of a given BIST process to a portion of a first expected pattern to determine a number of differences between the portion of the test pattern and the portion of the first expected pattern. Then, responsive to determining that the number of differences is below a threshold (e.g., less than half of the number of bits included in the portion of the test pattern and the portion of the first expected pattern), using the first expected pattern as the expected pattern for the given BIST process. However, responsive to determining that the number of differences is above the threshold (e.g., greater than half of the number of bits included in the portion of the test pattern and the portion of the first expected pattern), using a second expected pattern as the expected pattern for the given BIST process. In this manner, the synchronization circuit 242 can ensure that the test pattern received from the TX repair control circuit 360 is "in sync" with the expected pattern.

Then, after synchronizing the test pattern received from the TX repair control circuit 360 with the expected pattern, the error capture circuit 244 can be configured to compare the test pattern to the expected pattern (e.g., by performing an XOR operation, etc.). The error capture circuit 244 can be implemented using sticky flip-flops to capture the differences between the test pattern and the expected pattern. The register 246 can likewise be implemented using various suitable components, including using various quantities and configurations of flip-flops, latches, and/or other suitable components. The register 246 can be optionally included as part of the RX BIST circuit 240 and can be used to store any suitable data associated with the RX BIST circuit 240 (e.g., test patterns generated received from the TX BIST circuit 270, etc.).

Additionally, as shown in FIG. 3, the RX BIST circuit 240 can be configured to receive and operate in accordance with a clock signal 248 during the process of completing a BIST. The clock signal 248 can be the same as the clock signal 276, in some examples, and can generally be a faster clock signal than the clock signal used to operate components such as the die controller 220. For example, the die controller 220 and the TAP 210 can operate using a clock signal with a frequency in the range of tens of megahertz, whereas the clock signal 248 can have a frequency in the gigahertz range. The use of the clock signal 248 can generally improve the timing coordination of the BIST process performed by the integrated circuit 100 due to differences in communication frequencies that may exist between the TAP 210, the TAP 310, the die controller 220, and/or the die controller 320. Accordingly, the use of the clock signal 248 can help with detection of intermittent (e.g., partially failed) interconnects included in the interconnect layer 400 as well as completely failed interconnects included in the interconnect layer 400. Upon completion of the BIST process, the RX BIST circuit 240 can be configured to disconnect the clock signal 248.

The sequence of operations for the integrated circuit 100 when used with Automated Test Equipment (ATE) can include: (a) enabling the TX BIST circuit 270 through iJTAG (e.g., using the TAP 210 and the TAP 310); (b) enabling the RX BIST circuit 240 through iJTAG (e.g., using the TAP 210 and the TAP 310); (c) disabling the RX BIST circuit 240 and then subsequently disabling the TX BIST circuit 270 such that the signatures 235 (the repair decisions) are generated by the RX BIST circuit 240; (d) checking BIST results (e.g., pass/fail) through iJTAG (e.g., by accessing the test data register 233) and, if the results indicate a successful BIST (e.g., a "pass" indicating that there are no failed interconnects or that any failed interconnects can be successfully repaired with existing redundancy), shift the signatures from the 235 from the RX repair controller 232 to the die controller 220; (e) doing a soft repair by shifting out the signatures across the dice (e.g., from the die controller 220 on the first circuit die 200 to the second circuit die 300, such that the same signatures arrive at the RX repair control circuit 230 and the TX repair control circuit 360); (f) repeating the BIST sequence and collecting the BIST results (e.g., pass/fail) through iJTAG; and (g) burning a fuse (e.g., an e-fuse) if the BIST results indicate a successful BIST (pass). This sequence of operations can likewise be repeated (or performed in parallel) from the perspective of the second circuit die 300. Upon power up of the integrated circuit 100, the integrated circuit 100 can also enable automatic downloading of the signatures 235 and then activate repair functionality upon completion of the download.

The general BIST operation sequence for the integrated circuit 100 can include: (a) resetting the die controller 220, the TX BIST circuit 270, and the RX BIST circuit 240; (b) enabling BIST (e.g., enabling the TX BIST circuit 270 and the RX BIST circuit 240 through iJTAG), potentially including setting BIST modes, such that the TX BIST circuit 270 generates the test pattern and the RX BIST circuit 240 activates the synchronization circuit 242 and the error capture circuit 244; and (c) disabling BIST (e.g., disabling the TX BIST circuit 270 and the RX BIST circuit 240 through iJTAG), and then performing handshakes and overflow detection, where the repair decisions resulting from the BIST are stored as the signatures 235 and the overall BIST result (e.g., pass/fail) gets reported to the die controller 220 at the end of the operation. Again, this sequence of operations can likewise be repeated (or performed in parallel) from the perspective of the second circuit die 300. Viewed another way, the general BIST operation sequence for the integrated circuit 100 can include: (a) enabling TX (e.g., enabling the TX repair control circuit 360); (b) enabling RX (e.g., enabling the RX repair control circuit 230); (c) disabling RX (e.g., disabling the RX repair control circuit 230); and (d) disabling TX (e.g., disabling the TX repair control circuit 360).

The integrated circuit 100 can implement a method for repairing interconnects (e.g., in the interconnect layer 400) that electrically connect the first circuit die 200 and the second circuit die 300 in the integrated circuit 100 that more generally includes: (a) transmitting, from the first circuit die 200 to the second circuit die 300 via the interconnects, a test pattern; (b) determining, at the second circuit die 300, that a first interconnect of the interconnects has failed based on the test pattern received from the first circuit die 200; (c) generating, by the second circuit die, a signature (e.g., similar to the signatures 235) indicating that the first interconnect has failed; (d) transmitting, from the second circuit die 300 to the first circuit die 200, an instruction usable by the first circuit die 200 to deactivate the first interconnect and to activate a second interconnect of the interconnects based on the signature; (e) deactivating, by the second circuit die 300 based on the signature, the first interconnect; and (f) activating, by the second circuit die 300 based on the signature, the second interconnect. The method can further include storing, in a non-volatile memory of the second circuit die 300, the signature indicating that the first interconnect has failed.

## Claims

1. An integrated circuit (100), comprising:
a first circuit die (200) comprising a first die controller (220), a first TX repair control circuit (260), and a first RX repair control circuit (230);
a second circuit die (300) comprising a second die controller (320), a second TX repair control circuit (360), and a second RX repair control circuit (330); and
an interconnect layer (400) that electrically connects the first circuit die (200) and the second circuit die (300), wherein:
the first TX repair control circuit (260) is configured to transmit a test pattern to the second RX repair control circuit (330) via the interconnect layer (400);
the second RX repair control circuit (330) is configured to determine that a first interconnect in the interconnect layer (400) has failed based on the test pattern received from the first TX repair control circuit (260);
the second RX repair control circuit (330) is configured to transmit a signature indicating that the first interconnect has failed to the second die controller (320);
the first TX repair control circuit (260) is configured to deactivate the first interconnect and to activate a second interconnect in the interconnect layer (400) based on a first instruction received from the second die controller (320); and
the second RX repair control circuit (330) is configured to deactivate the first interconnect and to activate the second interconnect based on a second instruction received from the second die controller (320).

2. The integrated circuit (100) of claim 1, wherein:
the first TX repair control circuit (260) is configured to deactivate the first interconnect and activate the second interconnect via a first multiplexer on the first circuit die (200); and
the second RX repair control circuit (330) is configured to deactivate the first interconnect and activate the second interconnect via a second multiplexer on the second circuit die (300).

3. The integrated circuit (100) of claim 1 or 2, wherein the second RX repair control circuit (330) is configured to determine that the first interconnect has failed based on the test pattern received from the first TX repair control circuit (260) by comparing the test pattern to an expected pattern.

4. The integrated circuit (100) of claim 3, wherein the second RX repair control circuit (330) is configured to synchronize the test pattern and the expected pattern by:
comparing a portion of the test pattern to a portion of a first expected pattern to determine a number of differences between the portion of the test pattern and the portion of the first expected pattern;
responsive to determining that the number of differences is below a threshold, using the first expected pattern as the expected pattern; and
responsive to determining that the number of differences is above the threshold, using a second expected pattern as the expected pattern.

5. The integrated circuit (100) of claim 3 or 4, wherein the second RX repair control circuit (330) is configured to:
generate the signature by capturing differences between the test pattern and the expected pattern using sticky flip-flops; and
store the signature in a shift register of the RX repair control circuit.

6. The integrated circuit (100) of claim 5, wherein the second RX repair control circuit (330) is configured to disconnect a clock signal from the second RX repair control circuit (330) after the RX repair control circuit generates the signature.

7. The integrated circuit (100) of any of the claims 1 to 6, wherein the first TX repair control circuit (260) is configured to transmit the test pattern to the second RX repair control circuit (330) based on a third instruction received from a test access port, TAP, on the first circuit die (200).

8. The integrated circuit (100) of claim 7, wherein the test access port on the first circuit die (200) is configured to transmit the third instruction to the first TX repair control circuit (260) via a Segmented Instrument Access Network, SIAN, in accordance with Internal Joint Test Action Group, iJTAG, standards.

9. The integrated circuit (100) of any of claims 1 to 8, comprising at least one of the following features:
wherein the first die controller (220) does not receive any data indicative of failure of any of the interconnects from the second circuit die (300);
wherein the interconnect layer (400) comprises a hybrid copper bonding, HCB, interconnect layer (400).

10. The integrated circuit (100) of any of the claims 1 to 9, wherein:
the second TX repair control circuit (360) is configured to transmit a second test pattern to the first RX repair control circuit (230) via the interconnect layer (400);
the first RX repair control circuit (230) is configured to determine that a third interconnect in the interconnect layer (400) has failed based on the second test pattern received from the second TX repair control circuit (360);
the first RX repair control circuit (230) is configured to transmit a second signature indicating that the third interconnect has failed to the first die controller (220);
the second TX repair control circuit (360) is configured to deactivate the third interconnect and to activate a fourth interconnect in the interconnect layer (400) based on a fourth instruction received from the first die controller (220); and
the first RX repair control circuit (230) is configured to deactivate the third interconnect and activate the fourth interconnect based on a fifth instruction received from the first die controller (220);
in particular wherein the first die controller (220) does not receive any data indicative of failure of any of the interconnects from the second circuit die (300).

11. An integrated circuit (100), comprising:
a first circuit die (200) comprising a first die controller (220), a first TX repair control circuit (260), and a first RX repair control circuit (230);
a second circuit die (300) comprising a second die controller (320), a second TX repair control circuit (360), and a second RX repair control circuit (330); and
an interconnect layer (400) comprising interconnects that electrically connect the first circuit die (200) and the second circuit die (300), wherein:
the first TX repair control circuit (260) is configured to transmit a test pattern to the second RX repair control circuit (330) via the interconnect layer (400);
the second RX repair control circuit (330) is configured to determine that a first interconnect of the interconnects has failed based on the test pattern received from the first TX repair control circuit (260); and
the second RX repair control circuit (330) is configured to transmit a signature indicating that the first interconnect has failed to the second die controller (320) such that the second die controller (320) can use the signature to repair the first interconnect.

12. The integrated circuit (100) of claim 11, wherein the second RX repair control circuit (330) is configured to determine that the first interconnect has failed based on the test pattern received from the first TX repair control circuit (260) by comparing the test pattern to an expected pattern;
in particular wherein the second RX repair control circuit (330) is configured to generate the signature by storing differences between the test pattern and the expected pattern in a shift register.

13. A method for repairing interconnects that electrically connect a first circuit die (200) and a second circuit die (300) in an integrated circuit (100), the method comprising:
transmitting, from the first circuit die (200) to the second circuit die (300) via the interconnects, a test pattern;
determining, at the second circuit die (300), that a first interconnect of the interconnects has failed based on the test pattern received from the first circuit die (200);
generating, by the second circuit die (300), a signature indicating that the first interconnect has failed;
transmitting, from the second circuit die (300) to the first circuit die (200), an instruction usable by the first circuit die (200) to deactivate the first interconnect and to activate a second interconnect of the interconnects based on the signature;
deactivating, by the second circuit die (300) based on the signature, the first interconnect; and
activating, by the second circuit die (300) based on the signature, the second interconnect.

14. The method of claim 13, comprising at least one of the following features:
comprising storing, in a non-volatile memory of the second circuit die (300), the signature indicating that the first interconnect has failed;
wherein determining, by the second circuit die (300), that the first interconnect has failed comprises comparing, by the second circuit die (300), the test pattern received from the first circuit die (200) to an expected pattern.

15. The method of claim 13 or 14, wherein generating, by the second circuit die (300), the signature indicating that the first interconnect has failed comprises comparing, by the second circuit die (300), the test pattern received from the first circuit die (200) to an expected pattern;
wherein generating, by the second circuit die, the signature indicating that the first interconnect has failed comprises:
capturing, by the second circuit die (300), differences between the test pattern and the expected pattern using sticky flip-flops; and
storing the differences between the test pattern and the expected pattern in a shift register.
